# EUROPÄISCHE PATENTSCHRIFT

(11) **EP 2 539 486 B1**
(45) Veröffentlichungstag und Bekanntmachung des Hinweises auf die Patenterteilung: **30.08.2017**
(21) Anmeldenummer: 11701263.3
(22) Anmeldetag: 27.01.2011
(51) Int. Cl.: H01L 31/0749, C23C 18/12, H01L 21/02

(54) **BADABSCHEIDUNGSLÖSUNG ZUR NASSCHEMISCHEN ABSCHEIDUNG EINER METALLSULFIDSCHICHT UND ZUGEHÖRIGE HERSTELLUNGSVERFAHREN**
BATH DEPOSITION SOLUTION FOR THE WET-CHEMICAL DEPOSITION OF A METAL SULFIDE LAYER AND RELATED PRODUCTION METHOD
SOLUTION DE DÉPÔT EN BAIN CHIMIQUE POUR DÉPÔT CHIMIQUE PAR VOIE HUMIDE D'UNE COUCHE DE SULFURE MÉTALLIQUE ET PROCÉDÉ DE PRODUCTION ASSOCIÉ

(30) Priorität: 28.01.2010 DE 102010006499
(43) Veröffentlichungstag der Anmeldung: 02.01.2013
(73) Patentinhaber: Manz Cigs Technology GmbH, 74523 Schwäblsch Hall (DE)
(72) Erfinder: BÜRKERT, Linda, 74653 Künzelsau (DE); HARISKOS, Dimitrios, 70806 Kornwestheim (DE); KOLB, Torsten, 69126 Heidelberg (DE); SCHNELL, Bettina, 74597 Rechenberg (DE)
(74) Vertreter: Patentanwälte Ruff, Wilhelm, Beier, Dauster & Partner mbB
(86) Internationale Anmeldenummer: PCT/EP2011/051117
(87) Internationale Veröffentlichungsnummer: WO 2011/092236

(56) Entgegenhaltungen:
- US-A1- 2007 020 400
- US-A1- 2008 299 411
- JOHNSTON D A ET AL: "Chemical bath deposition of zinc sulfide based buffer layers using low toxicity materials", THIN SOLID FILMS, ELSEVIER-SEQUOIA S.A. LAUSANNE, CH, Bd. 403-404, 1. Februar 2002 (2002-02-01), Seiten 102-106, XP004430335, ISSN: 0040-6090, DOI: 10.1016/S0040-6090(01)01536-X
- LEJMI N ET AL: "The effect of heteropolyacids and isopolyacids on the properties of chemically bath deposited CdS thin films", SOLAR ENERGY MATERIALS AND SOLAR CELLS, ELSEVIER SCIENCE PUBLISHERS, AMSTERDAM, NL, Bd. 70, Nr. 1, 1. Dezember 2001 (2001-12-01), Seiten 71-83, XP004298832, ISSN: 0927-0248, DOI: 10.1016/S0927-0248(00)00412-8
- ENRIQUEZ J P ET AL: "Influence of the thickness on structural, optical and electrical properties of chemical bath deposited CdS thin films", SOLAR ENERGY MATERIALS AND SOLAR CELLS, ELSEVIER SCIENCE PUBLISHERS, AMSTERDAM, NL, Bd. 76, Nr. 3, 31. März 2003 (2003-03-31), Seiten 313-322, XP004404677, ISSN: 0927-0248, DOI: 10.1016/S0927-0248(02)00283-0
- LIANGYAN CHEN ET AL: "The Effects of the Complexing Agents on the Growth and Properties of Modified Chemical-bath-deposited ZnS Thin Films", NANO/MICRO ENGINEERED AND MOLECULAR SYSTEMS, 2006. NEMS '06. 1ST IEEE INTERNATIONAL CONFERENCE ON, IEEE, PI, 18. Januar 2006 (2006-01-18), Seiten 599-602, XP031063921, ISBN: 978-1-4244-0139-0

## Beschreibung

Die Erfindung bezieht sich auf eine Badabscheidungslösung zur nasschemischen Abscheidung einer Metallsulfidschicht, auf ein Verfahren zur Herstellung einer derartigen Badabscheidungslösung sowie auf ein Verfahren zur Herstellung einer Metallsulfidschicht auf einem Substrat unter Verwendung einer solchen Badabscheidungslösung. Die Erfindung eignet sich insbesondere zur nasschemischen Abscheidung ("chemical bath deposition"; CBD) einer Zinksulfidschicht (sog. CBD-Zinksulfidschicht) als Pufferschicht auf einer Absorberschicht bei der Fertigung von photovoltaischen Dünnschichtbauelementen. Unter derartigen CBD-Zinksulfidschichten sind vorliegend Schichten zu verstehen, die neben Zink und Schwefel herstellungsbedingt auch Sauerstoff in einem von den Präparationsbedingungen abhängigen Anteil enthalten können, weshalb die Schichten in der Fachliteratur formell auch als Zn(S,O)-Schichten oder ZnS₁₋ₓ,O,-Schichten mit 0≤x<1 oder Zn(S,O,OH)-Schichten oder ZnS(O,OH)-Schichten, bezeichnet werden.

Es sind speziell für die besagte ZnS-Pufferschichtabscheidung bei Solarzellenanwendungen bereits verschiedene Vorgehensweisen vorgeschlagen worden. So ist es beispielsweise aus den Offenlegungsschriften WO 2006/018013 A1 und DE 10 2006 039 331 A1 bekannt, hierfür eine Badabscheidungslösung zu verwenden, die in einer speziellen Weise aus Zinksulfat, Thioharnstoff und Ammoniak gelöst in destilliertem Wasser bereitet wird, wobei die Temperatur der Abscheidungslösung während des Abscheidungsprozesses auf 70°C bis 90°C gehalten oder auf einen derartigen Temperaturwert rampenförmig hochgefahren wird. Erfahrungsgemäß ist unter Verwendung dieses Abscheidungsprozesses zur Erzielung einer ZnS-Pufferschicht mit einer typischen benötigten Schichtdicke in der Größenordnung von 25nm eine Abscheidungsdauer von mindestens ca. 15 Minuten erforderlich.

ZnS-Pufferschichten haben sich als Alternative zu Cadmiumsulfid(CdS)-Pufferschichten in jüngerer Zeit sehr bewährt. So sind ZnS-Pufferschichten unter Umweltgesichtspunkten bekanntermaßen weniger problematisch als CdS-Pufferschichten, und es lassen sich damit transparentere Pufferschichten erzielen. Denn im Vergleich zu CdS hat ZnS einen höheren Bandabstand und absorbiert im Wellenlängenbereich zwischen 300nm bis 500nm kaum. Damit erreicht mehr Licht die photovoltaisch aktive Absorberschicht, was zu einer höheren Stromdichte und zu einem potentiell höheren Wirkungsgrad führt. Andererseits wird die kommerzielle Fertigung großflächiger Photovoltaikmodule z.B. vom sogenannten CIS- bzw. CIGS-Typ in jüngerer Zeit immer stärker nachgefragt. Es besteht daher großes Interesse an einem schnellen und kostengünstigen Prozess, mit dem ZnS-Pufferschichten in der benötigten Schichtqualität großflächig auf einem entsprechenden Substrat, d.h. einer entsprechenden Solarzellen-Absorberschicht, abgeschieden werden können. Dazu sind CBD-Zinksulfidschichten besonders auch dann von Interesse, wenn sie wie oben erläutert herstellungsbedingt Sauerstoff enthalten. Denn dadurch kann der Leitungsbandoffset gegenüber benachbartem CIS-Absorberschichtmaterial von etwa 1,6eV auf etwa 1,0eV oder weniger gesenkt werden. Je nach Sauerstoffgehalt und eventuellem Wasserstoff- bzw. Hydroxidgehalt kann es sich somit bei den CBD-Zinksulfidschichten um binäre Verbindungen aus den Elementen Zn und S, um ternäre Verbindungen aus den Elementen Zn, O und S bzw. den Bestandteilen Zn, S und OH, um quaternäre Verbindungen aus den Bestandteilen Zn, S, O und OH bzw. den Bestandteilen Zn, S, O und H oder um sauerstoff- und/oder wasserstoffdotierte ZnS-Schichten handeln, wobei natürlich auch gleitende Übergänge zwischen diesen Verbindungstypen je nach Anteil bzw. Dotierkonzentration des betreffenden Bestandteils möglich sind.

In dem Zeitschriftenaufsatz R. Sahraei et al., Compositional, structural, and optical study of noncrystalline ZnS thin films prepared by a new chemical bath deposition route, J. of Alloys and Compounds 466 (2008), Seite 488 ist ein ZnS-Pufferschichtabscheidungsverfahren offenbart, bei dem als Badabscheidungslösung eine schwach saure Lösung mit einem pH-Wert von etwa 5 verwendet wird, die Zinkchlorid (ZnSl₂), Nitrilotriessigsäure (NTA), Thioacetamid (TAA) und zur Einstellung des pH-Werts Natriumhydroxid (NaOH) enthält. Die Deposition erfolgt bis zu etwa 6 Stunden bei einer Temperatur von ca. 70°C, um eine Schichtdicke von ca. 80nm zu erzielen, wobei dieser Abscheidungsprozess bei Bedarf zur Erzielung höherer Schichtdicken wiederholt wird.

In dem Zeitschriftenaufsatz A. Goudarzi et al., Ammonia-free chemical bath deposition of nanocrystalline ZnS thin film buffer layer for solar cells, Thin Solid Films, 516 (2008), Seite 4953 ist ein ZnS-Pufferschichtabscheidungsverfahren offenbart, bei dem eine ammoniakfreie, schwach saure Badabscheidungslösung mit einem pH-Wert von ca. 6,0 verwendet wird, die Zinkacetat, TAA, NaOH zur Einstellung des pH-Werts und ein Natriumsalz von Ethylendiamintetraessigsäure (Na₂EDTA) gelöst in destilliertem Wasser enthält. Mit dieser Badabscheidungslösung werden Schichtdicken von ca. 20nm bis 140nm während Depositionsdauern von ca. 30min bis 7h für die abgeschiedene ZnS-Schicht erzielt.

### Neue Beschreibungsseiten 4, 5, 6 und 6a

In dem Zeitschriftenaufsatz S. Nagalingam et al., The Effect of EDTA on the Deposition of ZnS Thin Film, Z. Phys. Chem. 222 (2008), Seite 1703 wird als Alternative zur stromlosen nasschemischen Badabscheidung eine Elektrodeposition einer ZnS-Pufferschicht in einer deutlich sauren Abscheidungslösung mit einem pH-Wert von höchstens 4 und bevorzugt von ca. 1,26 vorgeschlagen, wobei die Abscheidungslösung ZnCl₂, Na₂S₂O₃, NaEDTA und Salzsäure (HCl) zur Einstellung des pH-Werts gelöst in destilliertem Wasser enthält.

In dem Zeitschriftenaufsatz D. A. Johnston et al., Chemical bath deposition of zinc sulfide based buffer layers using low toxicity materials, Thin Solid Films, 403-404 (2002), Seite 102 ist ein weiteres ZnS-Pufferschichtabscheidungsverfahren offenbart, bei dem für das Bad Zinksulfat, Harnstoff als Organosulfid sowie Ammoniumhydroxid und Trinatriumcitrat als Chelatkomplexbildner eingesetzt werden.

In dem Zeitschriftenaufsatz L. Chen et al., The Effects of the Complexing Agents on the Growth and Properties of Modified Chemical-bathdeposited ZnS Thin Films, Prog. of the 1st IEEE Int. Conf. on Nano/Micro Engineered and Molecular Systems, ISBN 978-1-4244-0139-0, Seite 599 ist ein ähnliches ZnS-Badabscheidungsverfahren offenbart, wobei als Zinkionenquelle Zinksulfat, Zinkchlorid und Zinknitrit und als Sulfidionenquelle unter anderem TAA, Thiosulfat und Harnstoff angegeben sind, gemäß den dortigen Untersuchungsergebnissen für die Badzusammensetzung jedoch Zinksulfat und Harnstoff in Kombination mit Ammoniumhydroxid, Hydrazinhydrat und Trinatriumzitrat offenbart und empfohlen werden.

In dem Zeitschriftenaufsatz N. Lejmi und O. Savadogo, The effect of heteropolyacids and isopolyacids on the properties of chemically bath deposited CdS thin films, Solar Energy Materials & Solar Cells 70 (2001), Seite 71 und in dem Zeitschriftenaufsatz J. P. Enriquez und Xavier Mathew, Influence of the thickness on structural, optical and electrical properties of chemical bath deposited CdS thin film, Solar Energy Materials & Solar Cells 76 (2003), Seite 313 sind CdS-Badabscheidungsverfahren offenbart, bei denen die Badzusammensetzung Cadmiumacetat, Harnstoff, Ammoniumhydroxid und Ammoniumacetat beinhaltet.

In der Offenlegungsschrift US 2007/0020400 A1 wird ein Verfahren zur kontinuierlichen Abscheidung dünner Schichten, wie beispielsweise ZnS- und CdS-Schichten, unter Verwendung eines Mikromischers und eines Mikrokanalapplikators offenbart. Im Mikromischer werden zwei vorzugsweise flüssige Reaktanden gemischt, um das für die Abscheidung gewünschte Depositionsmaterial bereitzustellen, beispielsweise für die Abscheidung einer CdS-Schicht eine Lösung aus Cadmiumchlorid, Ammoniumchlorid und Ammoniumhydroxid als erster Reaktand und wässrigen Harnstoff als zweiten Reaktand. Mit dem Mikrokanalapplikator wird dann das bereitgestellte Depositionsmaterial, z.B. in Form entsprechender CdS-Partikel für die Abscheidung einer CdS-Schicht, strahlförmig auf die zu beschichtende Fläche gerichtet.

Der Erfindung liegt als technisches Problem die Bereitstellung einer Badabscheidungslösung, eines zugehörigen Verfahrens zur Herstellung der Lösung sowie eines diese verwendenden Metallsulfidschicht-Herstellungsverfahrens zugrunde, welche die stromlose, nasschemische Abscheidung einer Metallsulfidschicht guter Qualität, wie sie beispielsweise für ZnS-Pufferschichten bei Solarzellenanwendungen benötigt wird, mit kurzer Depositionsdauer ermöglichen und sich insbesondere auch für großflächige Abscheidungen eignen, wie sie z.B. für ZnS-Pufferschichten bei der Fertigung großflächiger Photovoltaikmodule benötigt werden.

### Neue Beschreibungsseiten 6 und 6a

Die Erfindung löst dieses Problem durch die Bereitstellung einer Badabscheidungslösung mit den Merkmalen des Anspruchs 1, eines Badabscheidungslösungs-Herstellungsverfahrens mit den Merkmalen des Anspruchs 4 und eines Metallsulfidschicht-Herstellungsverfahrens mit den Merkmalen des Anspruchs 7. Vorteilhafte Weiterbildungen der Erfindung sind in den Unteransprüchen angegeben.

Charakteristischerweise beinhaltet die Badabscheidungslösung zur nasschemischen Abscheidung einer Metallsulfidschicht gemäß Anspruch 1 neben einem Salz des für die Metallsulfidschicht benötigten Metalls ein Organosulfid als Schwefelquelle für die Metallsulfidschicht, einen Chelatkomplexbildner, der mit Metallionen des Metallsalzes einen Chelatkomplex bildet, und Ammoniumhydroxid, wobei Thioacetamid (TAA) als Organosulfid und Nitrilotriessigsäure (NTA) oder Iminodiessigsäure (IDA) bzw. ein entsprechendes Salz dieser Säuren, z.B. ein Natriumsalz, Ammoniumsalz etc., als Chelatkomplexbildner eingesetzt wird. Gegebenenfalls können ein oder mehrere weitere Bestandteile in geringerer Konzentration enthalten sein.

Es zeigt sich, dass durch die Anwesenheit des Organosulfids als Schwefellieferant einerseits und sowohl des Chelatkomplexbildners als auch von Ammoniumhydroxid andererseits eine sehr vorteilhafte, schnelle Abscheidung einer Metallsulfidschicht auch auf größeren Flächen mit guter Qualität möglich ist, wofür das Zusammenspiel des Chelatkomplexbildners, der durch seine starke Abschirmwirkung die Zugänglichkeit der Metallionen für die aus dem Organosulfid freigesetzten Schwefelionen erschwert, und des Ammoniumhydroxids verantwortlich gemacht wird, wobei das Ammoniumhydroxid neben seiner Eigenschaft als den pH-Wert einstellendes Agens zusätzlich als schwache Metallionenabschirmkomponente fungiert. Die Erfinder haben festgestellt, dass sich mit dieser Zusammensetzung der Badabscheidungslösung z.B. ZnS-Pufferschichten mit einer Dicke von ca. 25nm während einer Depositionsdauer von weniger als ca. 10 min, insbesondere nur etwa ca. 4 min, mit guter Schichtqualität abscheiden lassen.

Es zeigt sich, dass bei Einsatz von TAA beispielsweise im Vergleich zu Thioharnstoff eine schnellere Schwefelfreisetzung erreichbar ist, was mit einer höheren Hydrolyseempfindlichkeit des TAA erklärt werden kann. Eine zu rasche Metallsulfidbildungsreaktion verbunden mit unerwünschten kolloidalen Ausscheidungen des Metallsulfids bzw. schlechten Bedeckungs-/Morphologiecharakteristika wird durch die kontrollierte Verlangsamung der Schwefelanlagerung an das Metallion aufgrund der Abschirmwirkung des Chelatkomplexbildners und des Ammoniumhydroxids bzw. Ammoniaks verhindert.

Es zeigt sich außerdem, dass mit NTA oder IDA bzw. einem entsprechendem Salz hiervon als Chelatkomplexbildner in Kombination speziell mit TAA als Organosulfid eine gute Anpassung der Freisetzungsgeschwindigkeit von Schwefel durch das Organosulfid und der durch den Chelatkomplexbildner verlangsamten Schwefelanlagerung an das Metallion derart erzielbar ist, dass sich die Metallsulfidschicht mit vergleichsweise sehr guter Qualität und hoher Depositionsrate von z.B. ca. 6nm/min abscheiden lässt.

Während zur Abscheidung von ZnS-Schichten, wie den besagten Pufferschichten für Solarzellenanwendungen, ein Zn-Salz als Metallsalz verwendet wird, können erfindungsgemäß in gleicher Weise andere Metallsulfidschichten, z.B. von In oder Kombinationen der Metalle Zn und In, unter Verwendung entsprechender Metallsalze nasschemisch abgeschieden werden.

In Ausgestaltung der Erfindung ist in der Badabscheidungslösung das Metallsalz in einer Konzentration von ca. 1 mM bis ca. 50mM und/oder das Organosulfid in einer Konzentration von ca. 1 mM bis ca. 150mM und/oder der Chelatkomplexbildner in einer Konzentration von ca. 0,01M bis ca. 1,0M und/oder das Ammoniumhydroxid in einer Konzentration von ca. 0,01M bis ca. 3,0M enthalten. Diese Konzentrationsbereiche haben sich zur Erzielung von Metallsulfidschichten guter Qualität mit ausreichend hoher Depositionsrate bei gleichzeitig vergleichsweise geringem Materialeinsatz als besonders geeignet erwiesen.

In weiterer Ausgestaltung der Erfindung wird für die Badabscheidungslösung ein pH-Wert im basischen Bereich bis in den neutralen Bereich eingestellt. Es zeigt sich, dass damit eine günstige nasschemische Abscheidung der Metallsulfidschicht erreicht werden kann.

Die erfindungsgemäße Badabscheidungslösung kann erfindungsgemäß mit geringem Aufwand durch einfaches Mischen der beteiligten Bestandteile in destilliertem Wasser hergestellt werden.

Unter Verwendung der erfindungsgemäßen Badabscheidungslösung lassen sich, wie erwähnt, Metallsulfidschichten auf einem Substrat mit vergleichsweise guter Schichtqualität und hoher Depositionsrate nasschemisch abscheiden. So ist beispielsweise die Deposition einer ZnS-Pufferschicht auf einem photovoltaischen Absorberschichtsubstrat mit diesem erfindungsgemäßen Verfahren möglich, wobei ohne Weiteres die für eine derartige Pufferschicht geforderte Schichtqualität und eine Schichtdicke von ca. 25nm mit sehr kurzen Depositionsdauern von höchstens etwa 10min und bevorzugt höchstens etwa 4min oder darunter erzielt werden können.

In Ausgestaltung dieses Metallsulfidschicht-Herstellungsverfahrens der Erfindung wird die Badlösung während des Abscheidungsprozesses auf einer Temperatur von ca. 40°C bis ca. 90°C gehalten.

In einer Weiterbildung der Erfindung beinhaltet das Inkontaktbringen des Substrats mit der Badabscheidungslösung ein Eintauchen des Substrats in die Badabscheidungslösung oder ein äquivalentes flächiges Inkontaktbringen der zu beschichtenden Substratfläche mit der Badabscheidungslösung durch eine entsprechende Benetzungs- oder Besprühtechnik.

Vorteilhafte Ausführungsformen der Erfindung sind in den Zeichnungen dargestellt und werden nachfolgend beschrieben. Hierbei zeigen:
- Fig. 1: eine schematische Darstellung einer Anlage zur nasschemischen Abscheidung einer Metallsulfidschicht,
- Fig. 2: eine Rasterelektronenmikroskopaufnahme einer Bruchkante einer mit der Anlage von Fig. 1 hergestellten CBD-Zinksulfidschicht auf einem CIGS-Substrat und
- Fig. 3: ein Strom-Spannungs-Kennliniendiagramm für ein Solarzellenmodul mit einer in der Anlage von Fig. 1 hergestellten CBD-Zinksulfidschicht.

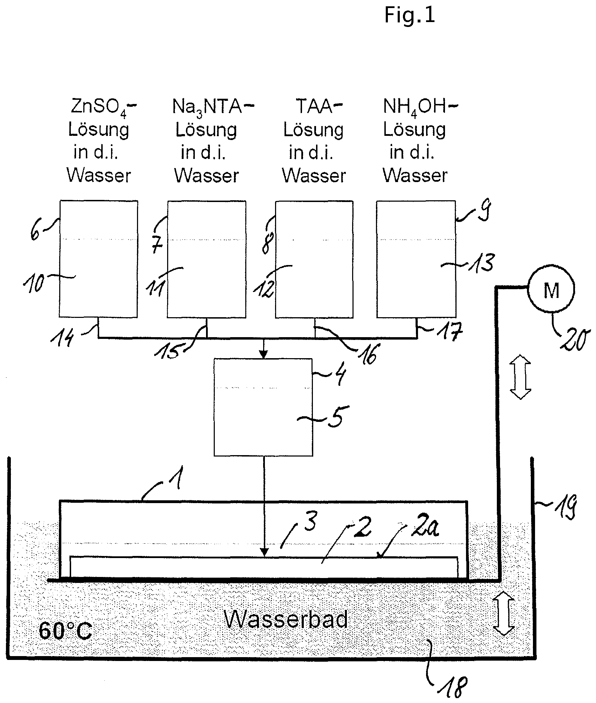

Die in Fig. 1 gezeigte Beschichtungsanlage dient zur nasschemischen Abscheidung von Metallsulfidschichten auf zugehörigen Unterlagen bzw. Substraten. Dazu weist die Beschichtungsanlage in an sich üblicher Weise einen Reaktorbehälter 1 auf, in den ein zu beschichtendes Substrat 2 eingebracht wird. Im Reaktorbehälter 1 wird ein chemisches Bad 3 bereitgestellt, in welches das zu beschichtende Substrat 2 insgesamt oder jedenfalls mit seiner zu beschichtenden Fläche 2a eingetaucht wird. Es versteht sich, dass alternativ zum Eintauchen die zu beschichtende Fläche 2a in anderer Weise mit dem chemischen Bad 3 geeignet in Kontakt gebracht werden kann, z.B. durch eine übliche Besprüh- oder Benetzungstechnik derart, dass ein Flüssigkeitsfilm der Badlösung 3 auf der zu beschichtenden Fläche 2a gebildet wird.

Das chemische Bad 3 wird dem Reaktorbehälter 1 über einen Mischbehälter 4 zugeführt, in welchem die verschiedenen Badbestandteile zur Bereitung einer entsprechenden chemischen Badlösung 5 gemischt werden. Speziell handelt es sich bei den Bestandteilen um ein Metallsalz, ein Organosulfid, einen Chelatkomplexbildner, der mit Metallionen des Metallsalzes einen Chelatkomplex bildet, und Ammoniumhydroxid. Im Beispiel von Fig. 1 wird jeder dieser vier Bestandteile als entsprechende Lösung in deionisiertem Wasser in einem jeweils zugehörigen Behälter 6, 7, 8, 9 bereitgestellt, d.h. als eine Metallsalzlösung 10, eine Chelatkomplexbildnerlösung 11, eine Organosulfidlösung 12 und eine Ammoniumhydroxidlösung 13. Jede dieser vier Lösungen kann über eine zugehörige Zufuhrleitung 14, 15, 16, 17 dem Mischbehälter 4 zugeführt werden. Lediglich als eines von vielen weiteren erfindungsgemäß möglichen Beispielen sei als Metallsalzlösung 10 die Bereitung einer Lösung von Zinksulfat (ZnSO₄) in deionisiertem Wasser, als Chelatkomplexbildnerlösung 11 die Bereitung einer Lösung von Nitrilotriessigsäuretrinatriumsalz (Na₃NTA) oder eines anderen Salzes von Nitrilotriessigsäure in deionisiertem Wasser und als Organosulfidlösung 12 die Bereitung einer Lösung von Thioacetamid (TAA) in deionisiertem Wasser genannt. Anstelle des Salzes von Nitrilotriessigsäure ist auch ein Salz von Iminodiessigsäure einsetzbar.Die vier Lösungskomponenten 10 bis 13 werden im Mischbehälter 4 bei Raumtemperatur in vorgebbaren Volumenverhältnissen vermischt, wobei diese Volumenverhältnisse so bestimmt werden, dass die verschiedenen chemischen Bestandteile im Mischbehälter 4, d.h. in der Badlösung 5, bestimmte vorgebbare Konzentrationen bzw. Anteile haben. Speziell wird der Mischungsprozess so gewählt, dass das Metallsalz, z.B. ZnSO₄, in einer Konzentration von ca. 1 mM bis ca. 50mM enthalten ist, z.B. in einer Konzentration von 5mM, der Chelatkomplexbildner, z.B. Na₃NTA, in einer Konzentration von ca. 0,01M bis 1,0M enthalten ist, z.B. in einer Konzentration von 0,1M, das Organosulfid, z.B. TAA, in einer Konzentration von ca. 1 mM bis ca. 150mM enthalten ist, z.B. in einer Konzentration von 5mM, und das Ammoniumhydroxid (NH₄OH) in einer Konzentration von ca. 0,01 M bis 3,0M, z.B. in einer Konzentration von 1M, enthalten ist.

Die im Mischbehälter 4 gemischte Badlösung 5 wird sofort nach dem Vermischen in den Reaktorbehälter 1 gegeben, um auf der zu beschichtenden Substratoberfläche 2a die nasschemische Abscheidung zu bewirken. Dazu wird das chemische Bad 3 während des nasschemischen Abscheidungsprozesses auf einer Temperatur von ca. 40°C bis ca. 90°C gehalten. In der Anlage von Fig. 1 wird dies dadurch bewirkt, dass der Reaktorbehälter 1 in ein entsprechend temperiertes, z.B. auf einer Temperatur von ca. 60°C gehaltenes Wasserbad 18 eintaucht, das sich in einem zugehörigen Wasserbadbehälter 19 befindet.

Wie weiter aus Fig. 1 ersichtlich, wird im dort gezeigten Ausführungsbeispiel der Reaktorbehälter 1 während des nasschemischen Abscheidungsprozesses gleichmäßig auf und ab bewegt, wozu ein entsprechender, reziprok arbeitender Hubmotor 20 vorgesehen ist.

Im genannten Beispiel einer ZnSO₄-Lösung als Metallsalzlösung scheidet sich unter den genannten Bedingungen auf der zu beschichtenden Substratoberfläche 2a nasschemisch eine ZnS-Schicht ab. Im Fall eines Photovoltaikmodulsubstrats scheidet sich diese Schicht als CBD-Zinksulfidschicht mit den oben erwähnten Eigenschaften auf der Substratoberfläche 2a ab, z.B. der Oberfläche einer CIS- bzw. CIGS-Absorberschicht.

Es zeigt sich, dass sich durch eine gleichmäßige Hubbewegung des Reaktors 1 und damit der zu beschichtenden Substratoberfläche 2a eine sehr homogene Metallsulfidschicht auf der zu beschichtenden Substratoberfläche 2a über eine relativ große Fläche hinweg erzielen lässt, z.B. für Modulflächen von 0,1m² bis 1m². Die gewählten Konzentrationsverhältnisse der Bestandteile im chemischen Bad 3 und die gewählte Wasserbadtemperatur beeinflussen die Dauer des Abscheidungsprozesses, die Schichtdicke und die Schichtqualität der abgeschiedenen CBD-Metallsulfidschicht, wie hinsichtlich Kristallinität, Bedeckungsgrad und Pinholedichte. Dabei zeigt sich, dass erfindungsgemäß bereits eine Depositions-/Reaktionszeit von deutlich weniger als 10min genügen kann, um beispielsweise eine CBD-Zinksulfidschicht als Pufferschicht mit einer ausreichenden Dicke von z.B. ca. 40nm auf einer Absorberschicht eines Photovoltaikmoduls zu bilden. Nach Beendigung des nasschemischen Abscheidungsprozesses wird das Substrat 2 aus dem Reaktor 1 entnommen, abgespült, z.B. mit destilliertem Wasser, und getrocknet, z.B. durch Trockenblasen mit Stickstoff.

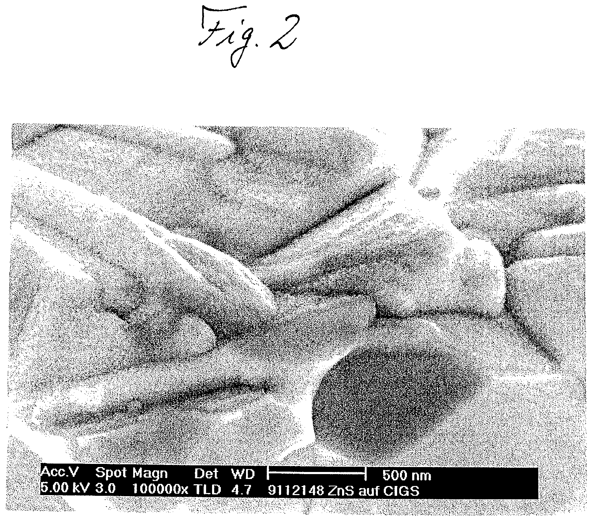

Somit kann durch die Verwendung des chemischen Bades 3 mit der geschilderten Zusammensetzung eine CBD-Zinksulfidschicht mit einer als Pufferschicht ausreichenden Dicke von ca. 40nm schon mit einer sehr kurzen Depositions-/Reaktionszeit von deutlich kleiner als 10min, z.B. von nur ca. 4min oder sogar noch weniger, auf der photovoltaischen Absorberschicht abgeschieden werden. Es zeigt sich weiter, dass die solchermaßen z.B. auf einer CIS- bzw. CIGS-Absorberschicht abgeschiedene CBD-Zinksulfidschicht gute Pufferschichteigenschaften aufweist. Dies ist auch aus der Rastermikroskopieaufnahme von Fig. 2 ersichtlich, aus der erkennbar ist, dass die nasschemisch abgeschiedene ZinksulfidPufferschicht auf der typischerweise relativ rauen CIGS-Absorberschichtoberfläche komplett geschlossen ist und eine perfekte Stufenabdeckung bereitstellt. Die ZnS-Pufferschicht zeigt dabei Körner mit typischen Abmessungen im Nanometerbereich.

Es zeigt sich weiter, das Metallsulfidschichten vergleichbarer Qualität alternativ zur erwähnten Eintauchtechnik auch dadurch erzielbar sind, dass die zu beschichtende Substratfläche mittels einer üblichen Benetzungs- oder Besprühtechnik mit der Badabscheidungslösung flächig in Kontakt gebracht wird, das heißt unter Bildung eines entsprechenden Flüssigkeitsfilms der Badabscheidungslösung auf der zu beschichtenden Substratfläche. In jedem Fall lässt sich durch dieses flächige Inkontaktbringen der zu beschichtenden Fläche mit der Badabscheidungslösung eine gewünschte heterogene Abscheidung der Metallsulfidschicht erzielen. Dieses heterogene Abscheidungsverhalten trägt zu einer hohen Schichtqualität ohne merkliche Partikelbildung bei, wie sie für homogene Abscheidungstechniken typisch ist, wobei sich die Partikelbildung homogener Abscheidungstechniken vorliegend als qualitätsbeeinträchtigend beweist. Beim vorliegenden Abscheidungsverfahren kommt dem Chelatkomplexbildner eine wichtige Rolle zur Einstellung einer gewünschten Reaktions-/Abscheidungskinetik zu.

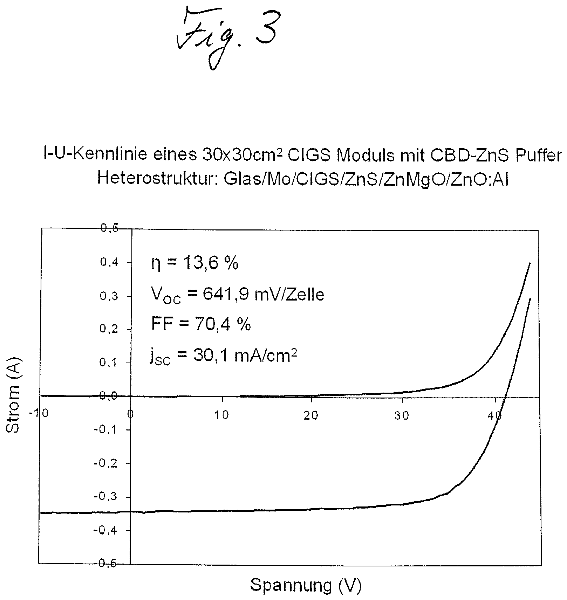

Fig. 3 veranschaulicht im Kennliniendiagramm wichtige elektrische Kenngrößen, wie sie an einem Photovoltaikmodul mit einer Flächenabmessung von 30cmx30cm gemessen wurden, das eine nach dem geschilderten, schnellen, nasschemischen Abscheidungsverfahren hergestellte CBD-Zinksulfidpufferschicht auf einer CIGS-Absorberschicht beinhaltet. Das beispielhaft betrachtete Modul besitzt einen Schichtaufbau aus einem Glassubstrat bzw. Glasträger, einer Rückkontaktschicht aus Molybdän auf dem Glasträger, einer CIGS-Absorberschicht auf der Rückkontaktschicht, der besagten, erfindungsgemäß aufgebrachten CBD-Zinksulfidpufferschicht auf der Absorberschicht, einer ZnMgO-Schicht als weitere Pufferschichtlage auf der CBD-Zinksulfidpufferschichtlage und einer ZnO:Al-Frontkontaktschicht auf der ZnMgO-Schicht. Mit Ausnahme der erfindungsgemäß hergestellten CBD-Zinksulfidpufferschicht handelt es sich hierbei um einen an sich herkömmlichen photovoltaischen Dünnschichtaufbau, wie er beispielsweise in der eingangs erwähnten Literatur beschrieben ist.

Die Abscheidung der CBD-Zinksulfidpufferschicht erfolgte für dieses Modul in einer Produktionsanlage nach Art von Fig. 1 auf einem Glassubstrat der Größe 60cmx120cm, auf das zuvor die Molybdän-Rückkontaktschicht und die CIGS-Absorberschicht aufgebracht wurden. Mit dem schnellen erfindungsgemäßen Depositionsprozess ergab sich eine sehr gute Homogenität der in einer Dicke von ca. 30nm während deutlich weniger als 10min aufgebrachten CBD-Zinksulfidpufferschicht. Das 60cmx120cm große Glassubstrat mit der erfindungsgemäß abgeschiedenen CBD-Zinksulfidpufferschicht wurde dann in 30cmx30cm große Module zerteilt. Fig. 3 zeigt die Kenngrößen eines solchen 30cmx30cm großen CIGS-Moduls. Wie daraus ersichtlich, ergeben sich für dieses Modul sehr gute photovoltaische Eigenschaften, wie ein Wirkungsgrad von 13,6%, eine Leerlaufspannung von 641,9 mV pro Einzelzelle, ein Füllfaktor von 70,4% und eine Kurzschluss-stromdichte von 30,1 mA/cm².

Es versteht sich, dass sich mit der Erfindung auch CBD-Zinksulfidschichten mit deutlich geringerer Dicke oder deutlich größerer Dicke als der oben beispielhaft erwähnten Dicke von etwa 40nm abgeschieden werden können, und dass in gleicher Weise auch andere Metallsulfidschichten auf einer photovoltaischen Absorberschicht oder irgendeiner anderen zu beschichtenden Substratoberfläche abgeschieden werden können. Charakteristisch ist jeweils die durch die erfindungsgemäße Badabscheidungslösung erzielbare kurze Depositionsdauer bzw. hohe Depositionsrate in Kombination mit guten Schichteigenschaften der nasschemisch abgeschiedenen Schicht, wie sie beispielsweise für Photovoltaikmodul-Pufferschichten gefordert werden. Wie sich für den Fachmann versteht, sind die verschiedenen Depositionsparameter und insbesondere die Anteile der verschiedenen Konstituenten der erfindungsgemäßen Badabscheidungslösung für den jeweiligen Einzelfall geeignet festzulegen, z.B. empirisch.

## Patentansprüche

1. Badabscheidungslösung zur nasschemischen Abscheidung einer Metallsulfidschicht,
- wobei die Badabscheidungslösung ein Metallsalz, ein Organosulfid, einen Chelatkomplexbildner, der mit Metallionen des Metallsalzes einen Chelatkomplex bildet, und Ammoniumhydroxid in destilliertem oder deionisiertem Wasser enthält,
- wobei das Metallsalz ein Zn- und/oder In-Salz ist, wobei
- das Organosulfid Thioacetamid ist und der Chelatkomplexbildner Nitrilotriessigsäure oder Iminodiessigsäure oder ein Metallsalz derselben ist.

2. Badabscheidungslösung nach Anspruch 1, weiter **dadurch gekennzeichnet, dass** das Metallsalz in einer Konzentration von 1 mM bis ca. 50mM enthalten ist und/oder das Organosulfid in einer Konzentration von 1 mM bis 150mM enthalten ist und/oder der Chelatkomplexbildner in einer Konzentration von 0,01M bis 1,0M enthalten ist und/oder das Ammoniumhydroxid in einer Konzentration von 0,01M bis 3,0M enthalten ist.

3. Badabscheidungslösung nach Anspruch 1 oder 2, weiter **dadurch gekennzeichnet, dass** sie einen pH-Wert im basischen Bereich aufweist.

4. Verfahren zur Herstellung einer Badabscheidungslösung zur nasschemischen Abscheidung einer Metallsulfidschicht, bei dem ein Metallsalz in Form eines Zn- und/oder In-Salzes, ein Organosulfid, ein Chelatkomplexbildner, der mit Metallionen des Metallsalzes einen Chelatkomplex bildet, und Ammoniumhydroxid in destilliertem oder deionisiertem Wasser gemischt werden, wobei als Organosulfid Thioacetamid verwendet wird und als Chelatkomplexbildner Nitrilotriessigsäure oder Iminodiessigsäure oder ein Metallsalz derselben verwendet wird.

5. Verfahren nach Anspruch 4, weiter **dadurch gekennzeichnet, dass** das Metallsalz in einer Konzentration von 1 mM bis 50mM in der hergestellten Badabscheidungslösung zugemischt wird und/oder das Organosulfid in einer Konzentration von 1 mM bis 150mM in der hergestellten Badabscheidungslösung zugemischt wird und/oder der Chelatkomplexbildner in einer Konzentration von 0,01M bis 1,0M in der hergestellten Badabscheidungslösung zugemischt wird und/oder das Ammoniumhydroxid in einer Konzentration von 0,01M bis 3,0M in der hergestellten Badabscheidungslösung zugemischt wird.

6. Verfahren nach Anspruch 4 oder 5, weiter **dadurch gekennzeichnet, dass** für die Badabscheidungslösung ein pH-Wert im basischen Bereich eingestellt wird.

7. Verfahren zur Herstellung einer Metallsulfidschicht auf einem Substrat, mit folgenden Schritten:
- Bereitstellen einer Badabscheidungslösung gemäß einem der Ansprüche 1 bis 3 und
- nasschemisches Abscheiden der Metallsulfidschicht auf dem Substrat durch Inkontaktbringen des Substrats mit der Badabscheidungslösung.

8. Verfahren nach Anspruch 7, weiter **dadurch gekennzeichnet, dass** das nasschemische Abscheiden zur Erzielung einer Schichtdicke der Metallsulfidschicht von 25nm für eine Dauer von höchstens 10min, insbesondere höchstens 4min, vorgenommen wird.

9. Verfahren nach Anspruch 7 oder 8, weiter **dadurch gekennzeichnet, dass** die Badabscheidungslösung während des nasschemischen Abscheidens auf einer Temperatur von 40°C bis 90°C gehalten wird.

10. Verfahren nach einem der Ansprüche 7 bis 9, weiter **dadurch gekennzeichnet, dass** als Metallsulfidschicht eine ZinksulfidPufferschicht auf einem photovoltaischen Absorberschichtsubstrat abgeschieden wird.

11. Verfahren nach einem der Ansprüche 7 bis 10, weiter **dadurch gekennzeichnet, dass** das Inkontaktbringen des Substrats mit der Badabscheidungslösung ein Eintauchen des Substrats in die Badabscheidungslösung oder ein flächiges Benetzen oder Besprühen des Substrats mit der Badabscheidungslösung beinhaltet.

## Claims

1. Bath deposition solution for wet-chemical deposition of a metal sulfide layer,
- wherein the bath deposition solution includes: a metal salt, an organosulfide, a chelating complexing agent forming a chelate complex with metal ions of the metal salt, and ammonium hydroxide in distilled or deionized water,
- wherein the metal salt is a Zn salt and/or In salt,
- wherein the organosulfide is thioacetamide and the chelating complexing agent is nitrilotriacetic acid or iminodiacetic acid or a metalt salt thereof.

2. Bath deposition solution according to claim 1, further **characterized in that** the metal salt is present in a concentration of from 1 mM to about 50 mM, and/or the organosulfide is present in a concentration of from 1 mM to 150 mM, and/or the chelating complexing agent is present in a concentration of from 0.01 M to 1.0 M, and/or the ammonium hydroxide is present in a concentration of from 0.01 M to 3.0 M.

3. Bath deposition solution according to claim 1 or 2, further **characterized in that** it has a pH value in the basic range.

4. Method for producing a bath deposition solution for wet-chemical deposition of a metal sulfide layer, wherein a metal salt in the form of a Zn salt and/or In salt, an organosulfide, a chelating complexing agent forming a chelate complex with metal ions of the metal salt, and ammonium hydroxide are mixed in distilled or deionized water, wherein the employed organosulfide is thioacetamide, and the employed chelating complexing agent is nitrilotriacetic acid or iminodiacetic acid or a metal salt thereof.

5. Method according to claim 4, further **characterized in that** the metal salt is admixed to the produced bath deposition solution in a concentration of 1 mM to 50 mM, and/or the organosulfide is admixed to the produced bath deposition solution in a concentration of 1 mM to 150 mM, and/or the chelating complexing agent is admixed to the produced bath deposition solution in a concentration of 0.01 M to 1.0 M, and/or the ammonium hydroxide is admixed to the produced bath deposition solution in a concentration of 0.01 M to 3.0 M.

6. Method according to claim 4 or 5, further **characterized in that** for the bath deposition solution a pH value is adjusted to a basic range.

7. Method for producing a metal sulfide layer on a substrate, comprising the following steps:
- providing a bath deposition solution according to any of claims 1 to 3, and
- wet-chemical deposition of the metal sulfide layer on the substrate by bringing the substrate into contact with the bath deposition solution.

8. Method according to claim 7, further **characterized in that** the wet-chemical deposition for obtaining a layer thickness of the metal sulfide layer of 25 nm is carried out for a period of at most 10 min, in particular at most 4 min.

9. Method according to claim 7 or 8, further **characterized in that** the bath deposition solution is maintained at a temperature of 40 °C to 90 °C during the wet-chemical deposition.

10. Method according to any of claims 7 to 9, further **characterized in that** a zinc sulfide buffer layer is deposited as metal sulfide layer on a photovoltaic absorber layer substrate.

11. Method according to any of claims 7 to 10, further **characterized in that** the contacting of the substrate with the bath deposition solution comprises dipping the substrate into the bath deposition solution or wetting or spraying the substrate over its area with the bath deposition solution.

## Revendications

1. Solution de dépôt en bain chimique pour déposition par voie humide d'une couche de sulfure métallique,
- la solution de dépôt en bain chimique comprenant un sel de métal, un organosulfure, un agent complexant de chélation formant un complexe chélaté avec des ions métalliques du sel de métal, et de l'hydroxyde d'ammonium dans l'eau distillée ou déionisée,
- le sel de métal étant un sel de Zn et/ou un sel de In,
- l'organosulfure étant le thioacétamide et l'agent complexant de chélation étant l'acide nitrilotriacétique ou l'acide iminodiacétique ou un sel de métal desdits.

2. Solution de dépôt en bain chimique selon la revendication 1, en outre **caractérisée en ce que** le sel de métal est présent dans une concentration de 1 mM à environ 50 mM et/ou l'organosulfure est présent dans une concentration de 1 mM à 150 mM et/ou l'agent complexant de chélation est présent dans une concentration de 0,01 M à 1,0 M et/ou l'hydroxyde d'ammonium est présent dans une concentration de 0,01 M à 3,0 M.

3. Solution de dépôt en bain chimique selon la revendication 1 ou 2, en outre **caractérisée en ce que** la solution présente une valeur pH dans la plage basique.

4. Procédé de production d'une solution de dépôt en bain chimique pour déposition par voie humide d'une couche de sulfure métallique, dans lequel un sel de métal sous forme d'un sel de Zn et/ou d'un sel de In, un organosulfure, un agent complexant de chélation formant un complexe chélaté avec des ions métalliques du sel de métal, et de l'hydroxyde d'ammonium sont mélangés dans l'eau distillée ou déionisée, dans lequel l'organosulfure utilisé est le thioacétamide et l'agent complexant de chélation utilisé est l'acide nitrilotriacétique ou l'acide iminodiacétique ou un sel de métal desdits.

5. Procédé selon la revendication 4, en outre **caractérisé en ce que** le sel de métal est ajouté à une concentration de 1 mM à 50 mM dans la solution de dépôt en bain chimique produite et/ou l'organosulfure est ajouté à une concentration de 1 mM à 150 mM dans la solution de dépôt en bain chimique produite et/ou l'agent complexant de chélation est ajouté à une concentration de 0,01 M à 1,0 M dans la solution de dépôt en bain chimique produite et/ou l'hydroxyde d'ammonium est ajouté à une concentration de 0,01 M à 3,0 M dans la solution de dépôt en bain chimique produite.

6. Procédé selon la revendication 4 ou 5, en outre **caractérisé en ce qu'**une valeur pH dans la plage basique est ajustée pour la solution de dépôt en bain chimique.

7. Procédé de production d'une couche de sulfure métallique sur un substrat, comprenant les étapes suivantes :
- préparer une solution de dépôt en bain chimique selon l'une quelconque des revendications 1 à 3, et
- déposer par voie humide de la couche de sulfure métallique sur le substrat par contacter le substrat et la solution de dépôt en bain chimique.

8. Procédé selon la revendication 7, en outre **caractérisé en ce que** pour obtenir une épaisseur de couche de la couche de sulfure métallique de 25 nm la déposition par voie humide s'effectue pendant une durée d'au maximum 10 min, en particulier d'au maximum 4 min.

9. Procédé selon la revendication 7 ou 8, en outre **caractérisé en ce que** pendant la déposition par voie humide la solution de dépôt en bain chimique est maintenue à une température de 40 °C à 90 °C.

10. Procédé selon l'une quelconque des revendications 7 à 9, en outre **caractérisé en ce qu'**une couche tampon de sulfure de zinc se dépose en tant que couche de sulfure métallique sur un substrat de couche absorbante photovoltaïque.

11. Procédé selon l'une quelconque des revendications 7 à 10, en outre **caractérisé en ce que** contacter le substrat avec la solution de dépôt en bain chimique comprend trempage du substrat dans la solution de dépôt en bain chimique ou mouillage ou aspersion du substrat sur une grande étendue avec la solution de dépôt en bain chimique.
